# EUROPEAN PATENT SPECIFICATION

(11) **EP 0 373 899 B1**
(45) Date of publication and mention of the grant of the patent: **01.03.1995**
(21) Application number: 89312996.5
(22) Date of filing: 12.12.1989
(51) Int. Cl.: C30B 15/00

(54) **Monocrystal ingot pulling apparatus**
Vorrichtung zur Ziehung von Einkristallstangen
Appareil de tirage de lingots monocristallins

(30) Priority: 12.12.1988 JP 311857/88
(43) Date of publication of application: 20.06.1990
(73) Proprietor: SHIN-ETSU HANDOTAI COMPANY LIMITED, Chiyoda-ku Tokyo (JP)
(72) Inventor: Iwasaki, Atsushi, Takefu-shi Fukui-ken (JP)
(74) Representative: Whalley, Kevin

(56) References cited:
- DE-A- 3 905 626
- FR-A- 2 329 343

## Description

The present invention relates to a monocrystal ingot pulling apparatus based on CZ (Czochralski) method for manufacturing semiconductor monocrystal ingots.

This kind of monocrystal ingot pulling apparatus has a hermetic chamber in which are installed articles such as a purge duct means for introducing an inert gas into the chamber, a crucible to contain a molten semiconductor substance to be crystallized, a heater surrounding the crucible, and a heat insulator surrounding the heater. The heater and the heat insulator, etc. are usually made of solid carbon or a fibrous carbonaceous material so that when they are heated at high temperatures, they release a mixture of carbon oxides and these gases are absorbed or dissolved in the molten semiconductor substance in the crucible whereby the carbon content of the monocrystal ingot to be pulled from the melt is increased, which causes various inconveniences. For example, the increased carbon content of semiconductor material, e.g. silicon, causes various crystal defects such as dislocation, and the resulting semiconductor monocrystal ingot is poor in electric properties.

Therefore, it is a common practice that an inert gas such as argon gas is softly blown through a vertical purge duct means over the surface of the molten semiconductor material in the crucible in the chamber so that the atmospheric gas already contaminated with carbon oxides is prevented from coming in contact with the molten semiconductor material to thereby avoid the above inconveniences.

This type of monocrystal ingot pulling apparatus is usually designed such that it is possible to supply the semiconductor raw material to replenish the crucible (which is called "recharging") without significantly lowering the furnace temperature. This kind of design is essential to high productive efficiency, because if the chamber has to be cooled down for replenishment of the semiconductor raw material each time the crucible becomes nearly empty, the monocrystal ingot pulling operation must be terminated. Once the termination occurs considerable length of the downtime is necessary to start up the next operation. What is more, when the furnace is cooled down to solidify the melt, a stress caused by the difference in thermal expansion coefficient between the crucible and the solidified semiconductor material causes breakage of the expensive crucible.

However, with the conventional monocrystal ingot pulling apparatuses, it was not designed to adjust the altitudinal position of the vertical purge duct means, so that the outlet of the purge duct means cannot be brought to the optimum positions at such times as charging the initial supply of the semiconductor raw material in the crucible, dipping the seed crystal in the melt to initiate crystallization (seeding), and replenishing the crucible (recharging) with additional supply of the semiconductor raw material. Especially on the occasion of recharging, when the surface of the melt is solidified, it is very important that a sufficient space is provided between the solidified surface of the melt and the purge duct means, by way of which lumps of the semiconductor raw material are more easily recharged, lest the earlier supply of the semiconductor raw material laid on the surface should interfere with the later supply. However, since the conventional purge duct means is stationary and cannot be moved vertically, it was impossible to optimize the height of the purge duct means at respective times of initial charging, seeding and recharging, so that on the occasion of recharging, for example, the space between the purge duct means and the solidified melt surface is too small to facilitate smooth recharging of the semiconductor raw material.

Therefore, this invention was contrived in view of the above problem, and it is an object of the invention to provide a monocrystal ingot pulling apparatus which is adapted to optimize the space between the outlet of the purge duct means and the surface of the melt of the semiconductor substance by means of remote controlling, without affecting the originally intended performance of the purge duct means, so that the operations of charging, seeding and recharging will be smooth.

In order to attain the above-described object and others, the inventors contrived an improved Czochralski method-type monocrystal ingot pulling apparatus having a hermetic chamber in which are installed a vertical purge tube for introducing an inert gas into the chamber, a crucible for containing a molten semiconductor substance to be crystallized, a heater surrounding the crucible, and a heat insulator surrounding the heater, the said hermetic chamber including a cover having a vertical cylindrical neck portion, characterized in that said purge tube is vertically slidably inserted in a vertical purge tube holder and is adapted to be hooked by the holder just before it passes therethrough, which holder is itself vertically shiftable inside the vertical cylindrical neck portion of the cover of the chamber, that said purge tube holder is hung by three wires connected to the outside of the holder near the lower end thereof at locations equidistant from each other, and that the other end of each wire is passed around a respective small pulley provided in a respective recess made in the inner circumference of a flange, and passed horizontally in a passage made in said flange and a horizontal pipe hermetically and radially connected to said flange, and eventually wound up by a winder mechanism, by operation of which said purge tube is vertically shifted together with said purge tube holder

In accordance with the present invention, when lumps of the semiconductor raw material are to be recharged, the vertically provided purge duct means is hoisted by operating the drive mechanism such that the distance between the lower end of the purge duct means and the melt surface becomes large enough to enable smooth supply of sufficient amount of the semiconductor raw material. Also, on the occasion when the seed crystal is dipped in the melt to initiate crystallization or when the monocrystal ingot is pulled up, the purge duct means is lowered by operating the drive mechanism such that the distance between the lower end of the purge duct means and the melt surface becomes small enough to enable the inert gas softly blown from the purge duct means to purge away the carbon oxides which tends to flow into the crucible and come over the melt from outside of the crucible.

Thus, in accordance with the invention, it is possible to supply sufficient amounts of semiconductor raw material without degradation of the performance of the purge duct means.

The above and other objects and features of the invention will appear more fully hereinafter in the following description given in connection with the accompanying drawings and the novelty thereof pointed out in the appended claims.
Fig. 1 is a vertical sectional view of an embodiment of the monocrystal ingot pulling apparatus according to the invention;
Fig. 2 is an enlarged detailed vertical sectional view of the upper and a middle portions of the apparatus of Fig. 1, the intermediate portion thereof being removed, which is useful for explaining the loop wheel mechanism;
Fig. 3 is a top plan view of the loop wheel mechanism consisting of three loop wheel assemblies;
Fig. 4 is an enlarged and partially cutaway top plan view of the drive means of one of the loop wheel assemblies;
Fig. 5 is a partially cutaway view of the drive means of Fig. 4 seen in the direction of the arrow A in Fig. 4;
Fig. 6 is a vertical sectional view of the monocrystal ingot pulling apparatus as of the time of melting the lumps of semiconductor raw material in the crucible;
Fig. 7 is a similar view of Fig. 6 as of the time of seeding, the seed and the holder thereof being not shown for simplicity;
Fig. 8 is a similar view of Fig. 6 as of the time of recharging; and
Fig. 9 is a vertical sectional view of a conventional monocrystal ingot pulling apparatus as of the time of recharging.

Next, one of the preferred embodiments of the present invention will be explained with reference to the drawings.

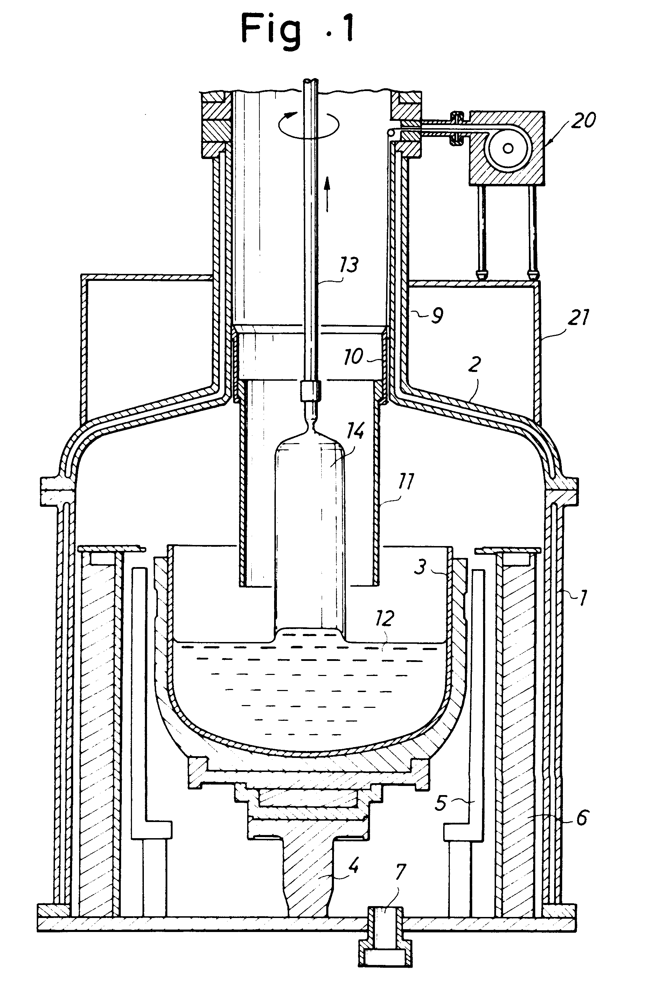

First, as shown in Fig. 1, the monocrystal ingot pulling apparatus according to the invention basically comprises: a hermetic chamber consisting of a cylindrical main body 1, a cover 2 hermetically covering the cylindrical main body 1, and a bottom floor; a quartz crucible 3 supported by an adjustable support assembly 4 provided in the bottom of the chamber capable of adjusting the height of the crucible 3; a cylindrical heater 5 made of carbon material and surrounding the crucible 3 in the chamber; a cylindrical insulator 6 made of carbon material and surrounding the heater 5; and an exhaust port 7 provided in the bottom floor of the chamber.

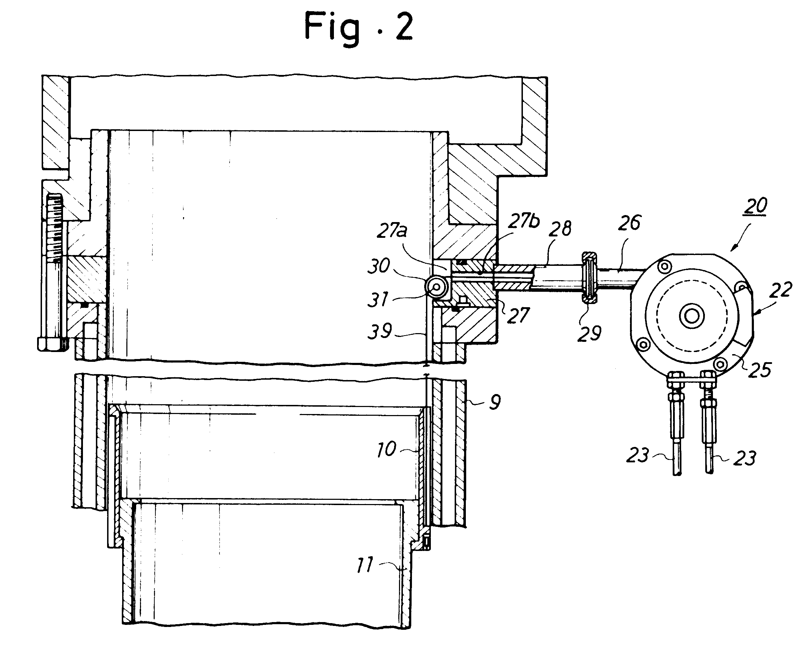

The cover 2 consists of a vertical cylindrical neck portion 9 and a shoulder portion. A cylindrical purge tube holder 10 is provided in, and adapted to slide along, the vertical cylindrical neck 9 of the cover 2. A cylindrical purge tube 11 for providing a passage for an inert gas to enter the hermetic chamber is adapted to slide through the purge tube holder 10. The lower end of the holder 10 has an inwardly projecting rim and the upper end of the purge tube 11 has an outwardly projecting rim which is adapted to be hooked by the inwardly projecting rim of the holder 10 so that the purge tube 11 is prevented from falling off the holder 10. The holder 10 and the purge tube 11 are adapted to be lifted by a loop wheel mechanism, of which the main body is provided on a horizontal footing 21 fixed on the shoulder portion of the cover 2 . Next, with reference to Figs. 2 through 5, the loop wheel mechanism will be explained in detail.

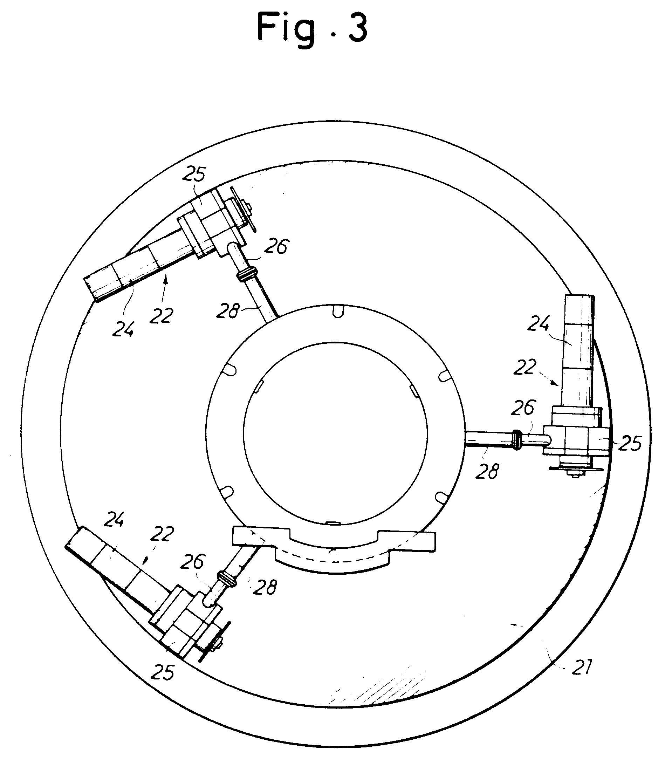

As shown in Figs. 2 and 3, the loop wheel mechanism in this embodiment consists of three loop wheel assemblies 20 which are arranged equiangularly around the neck portion of the cover 2 and on the footing 21, that is, each loop wheel assembly 20 is 120° apart from the other assemblies 20. The drive means 22 of each of the loop wheel assembly 20 is supported by means of a pair of bolts 23 whose lengths can be adjusted. These bolts 23 stand on the horizontal footing 21.

Each drive means 22 comprises a housing 25, to which a DC servomotor 24, as the drive source, equipped with an encoder is kinetically connected. A straight pipe 26 extends generally tangentially from the housing 25 and towards the center line of the cylindrical neck portion of the cover 2. The pipe 26 is connected by means of a coupling 29 to a straight pipe 28, which extends radially from a flange 27 provided in a guide means 9. A pulley 30 of a small diameter is pivotally provided on a shaft 31 in a recess 27a made in the inner circumference of the flange 27.

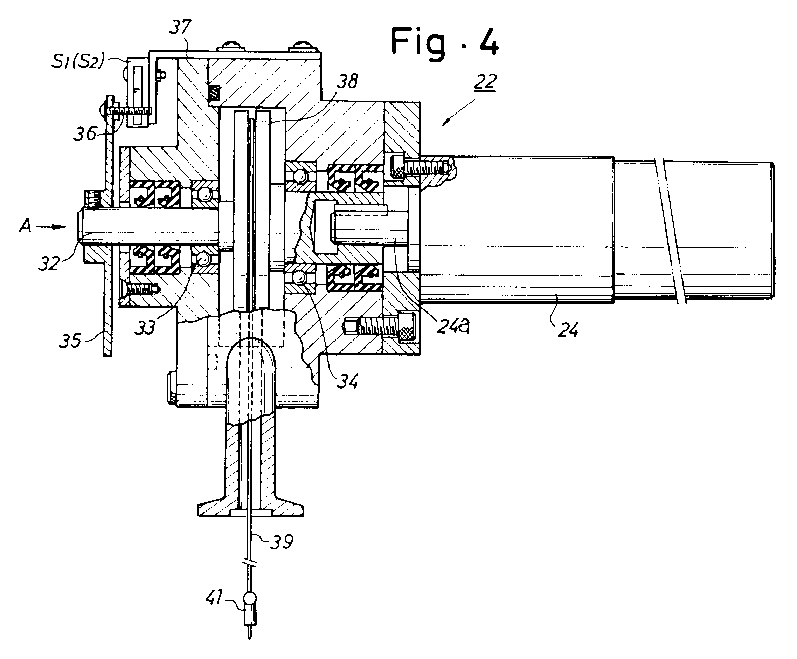

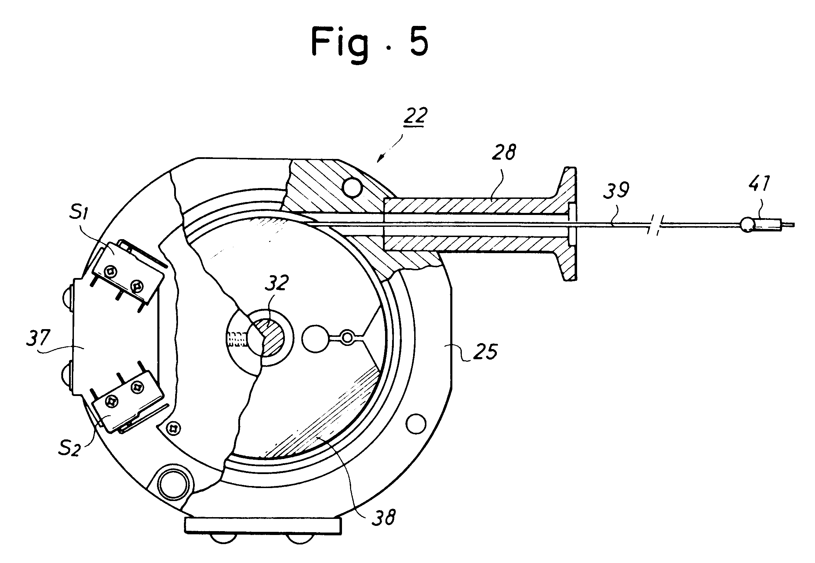

Next, the detail of the interior of the housing 25 will be described with reference to Figs. 4 and 5. Reference numeral 32 designates a stepped shaft rotatably supported on ball bearings 33 and 34. The thick end of the stepped shaft 32 is fixedly connected with the end of the output shaft 24a of the DC servomotor 24 so that the shaft 32 rotates together with the output shaft 24a. A turn disc 35 is locked about the narrow end of the stepped shaft 32, which extends out of the housing 25. A screw-threaded pin 36 is screwed through a threaded hole made in the turn disc 35 at a location near the periphery of the turn disc 35. The pin 36 is thus fixed normally to the face of the turn disc, and protrudes toward the DC servomotor 24. The pin 36 therefore traces a circle as the turn disc 35 turns with the shaft 32. A support means 37 having an L-shaped profile, of which the longer segment is horizontal and the shorter segment is vertical, is attached to a side of the housing 25 by means of screws which fix the longer segment to the housing side. Limit switches S₁ and S₂ are provided on the external face of the vertical and shorter segment of the L-shaped support means 37. The limit switches S₁ and S₂ are positioned such that when the pin 36 traces the circular locus counterclockwise, as seen in the direction of arrow A in Fig. 4, the pin 36 is stopped by a resilient contactor (Fig. 5) of the switch S₁ thereby turning on the switch S₁ , and when it traces the circular locus clockwise it is stopped by a resilient contactor of the switch S₂ thereby turning on the switch S₂.

A pulley 38 having a relatively large diameter is integrally provided about the middle of the shaft 32 where the shaft is stepped. A wire 39 is wound around the pulley 38. The unwound portion of the wire 39 is passed horizontally through the pipe 26, the pipe 28, and a straight passage 27b made in the flange 27; then the wire 39 is passed around the pulley 30, from which the wire extends downward and passes through a vertical groove made in the side of the purge tube holder 10 (Fig. 2). The free end of the wire 39 is then passed through a vertical hole made in a node in the vertical groove. The node is provided near the lower end of the holder 10. A stopper 41 having a spherical portion of a diameter greater than the diameter of the hole in the node is provided at the end of the wire 39. Therefore, the holder 10 and the purge tube 11, which is held by the holder 10, are hung by the three wires 39.

Incidentally, a controller (not shown) is electrically connected to the three DC servomotors 24, for simultaneously controlling these servomotors.

Next, the operation of the monocrystal ingot pulling apparatus of this embodiment of the invention will be explained.

In the monocrystal ingot pulling apparatus of Fig. 1, a silicon monocrystal ingot 14 is pulled in accordance with the Czochralski method. To obtain such a silicon monocrystal ingot, lumps of silicon raw material of appropriate sizes are first charged in the crucible 3; then these lumps are heated and melted by means of the heater 5; a silicon seed crystal fixed at the lower end of the pulling shaft 13 is dipped in the surface of the silicon melt 12 in the crucible 3; and the pulling shaft 13 is slowly turned and pulled up at a rate of several milimeters per minute. During this operation, an inert gas such as argon gas is supplied through the purge tube 11 to prevent the carbon oxides released by the heated portions of the heater 5 and the insulator 6 from dissolving in the silicon melt 12, to thereby keep the carbon content of the silicon monocrystal ingot 14 lower than a desired minimum value, such as 0.05 ppm. The argon gas together with the carbon oxides is exhausted from the chamber by way of the exhaust port 7. Also, with the help of the recharging devices, lumps of the silicon raw material can be easily recharged in the crucible 3 even while the apparatus is not substantially cooled but close to the running temperature.

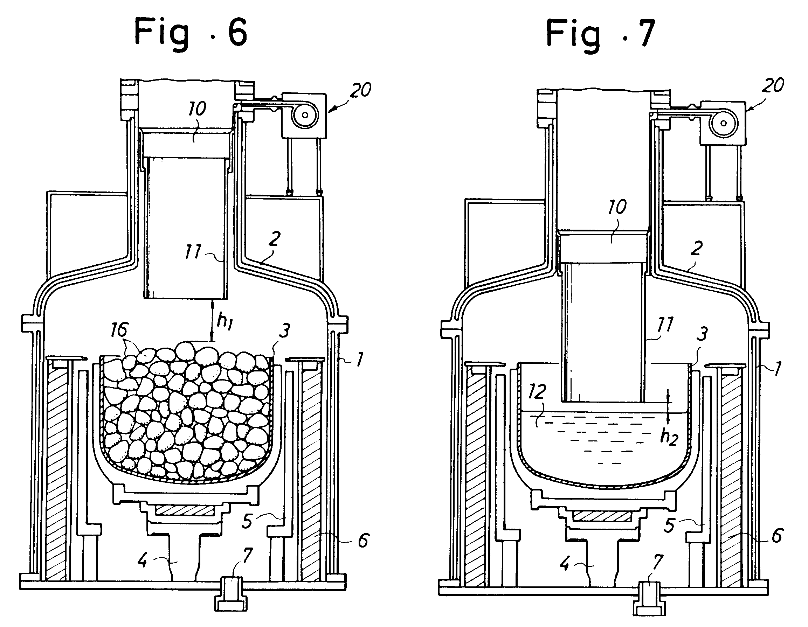

In the monocrystal ingot pulling apparatus of this embodiment of the invention, at the time the initial batch of silicon raw material 16 is charged, which is done while the heater 5 and all other elements are at the room temperature, the purge tube 11 is pulled higher to a location as shown in Fig. 6. On this occasion no argon gas is supplied through the purge tube 11. The ample space thus provided between the lower end of the purge tube 11 and the crucible 3 allows smooth charging of the silicon lumps of appropriate sizes in the crucible 3. Incidentally, the monocrystal ingot pulling apparatus of this embodiment is designed such that it is possible to charge 60 kg of silicon raw material 16 as the initial charge. The vertical distance h₁ between the lower end of the purge tube 11 and the top of the charged silicon raw material is preferably about 120 mm. On this occasion the purge tube holder 10 is kept at its highest position.

As the heating by means of the heater 5 proceeds, the silicon raw material 16 in the quartz crucible 3 collapses and melts to form the silicon melt 12. As the collapsing and melting of the silicon lumps proceed, the argon gas is supplied through the purge tube 11, and the holder 10 is lowered gradually by means of the three loop wheel assemblies 20 which are operated simultaneously. When the melting is completed, the vertical distance h₂ from the lower end of the purge tube 11 to the surface of the melt 12 is preferably about 50 mm, as shown in Fig. 7. With the purge tube 11 kept at this position, the seeding operation is conducted to initiate the growth of the silicon monocrystal ingot 14.

During the seeding and the subsequent pulling operation, the flow rate of the argon gas through the purge tube 11 is maintained such that it is not too large to roughen the surface of the melt 12 but large enough to prevent the carbon oxides from entering the crucible from outside.

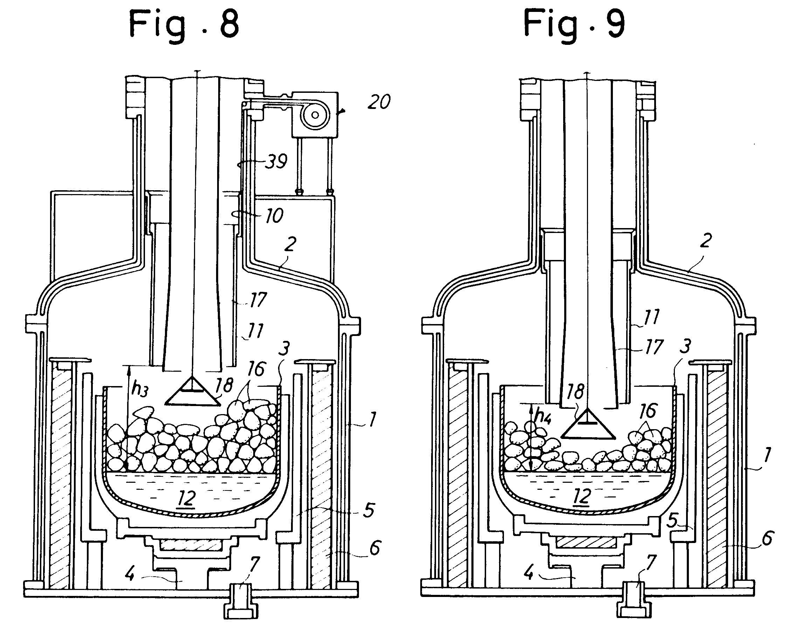

When the seeding is completed, the monocrystal ingot 14 is gradually raised; and before the next monocrystal ingot is pulled, if the amount of the remnant of the melt 12 in the crucible is too small, recharging of the silicon raw material 16 is carried out in a manner shown in Fig. 8. First, the heating temperature is slightly reduced for the purpose of allowing the surface of the melt 12 to solidify. Next, by means of the controller, not shown, the DC servomotors 24 of the drive means 22 of the three loop wheel assemblies 20 are simultaneously operated such that the shafts 32 together with the pulleys 39 rotate counterclockwise, as viewed in the direction of arrow A in Fig. 4, and the three wires 39 are simultaneously wound about the pulleys 39, and the purge tube holder 10 together with the purge tube 11 is raised. When the screw-threaded pin 36 fixed to the turn disc 35 in each drive means 22 comes in contact with the resilient contactor of the switch S₁ , the pin 36 presses the contactor to thereby turn on the switch S₁ whereupon the operation of the DC servomotor 24 is halted. Therefore, at this moment the holder 10 assumes its highest possible position (Fig. 8). Meanwhile, the support assembly 4 is operated to sink in the floor of the chamber to lower the crucible 3 in the chamber, whereby an ample space is provided between the purge tube 11 and the solidified surface of the melt 12 in the quartz crucible 3.

In Fig. 8, the crucible 3 preferably contains 36 kg of silicon melt 12 of which only the surface is solidified, and the distance h₃ between the silicon melt 12 and the lower end of the purge tube 11 is preferably maintained at 272 mm.

Thus, an ample space for recharging lumps of silicon is provided so that as much as 14 kg of silicon raw material 16 is smoothly supplied onto the surface of the melt 12 through a supply pipe 17. Incidentally, the device designated by reference numeral 18 is a conical buffer suspended by a wire for facilitating uniform distribution of lumps of silicon raw material 16 all over the surface of the melt 12.

Fig. 9 shows a conventional monocrystal ingot pulling apparatus wherein no loop wheel mechanism is provided. With this apparatus, on the occasion of recharging, even if the crucible 3 is lowered by means of the support means 4, the distance h₄ between the lower end of the purge tube 11 and the solidified surface of the melt 12 becomes only about 170 mm at most, so that only about 7 kg of silicon raw material 16 can be recharged into the crucible 3 which is one half of the recharge amount possible with the apparatus of the present invention.

The invention being thus described, it will be obvious that the same may be varied in many ways. For example, in pace of the purge tube holder 10 and the purge tube 11, it is possible to employ a telescopic tube which is arbitrarily extensible and compressible by means of a drive means.

## Claims

1. A monocrystal ingot pulling apparatus having a hermetic chamber (1, 2) in which are installed a vertical purge tube (11) for introducing an inert gas into the chamber, a crucible (3) for containing a molten semiconductor substance to be crystallized, a heater (5) surrounding the crucible (3), and a heat insulator (6) surrounding the heater (5), the said hermetic chamber (1, 2) including a cover (2) having a vertical cylindrical neck portion (9), characterized in that said purge tube (11) is vertically slidably inserted in a vertical purge tube holder (10) and is adapted to be hooked by the holder (10) just before it passes therethrough, which holder (10) is itself vertically shiftable inside the vertical cylindrical neck portion (9) of the cover of the chamber, that said purge tube holder (10) is hung by three wires (39) connected to the outside of the holder near the lower end thereof at locations equidistant from each other, and that the other end of each wire (39) is passed around a respective small pulley (30) provided in a respective recess (27a) made in the inner circumference of a flange (27), and passed horizontally in a passage (27b) made in said flange (27) and a horizontal pipe hermetically and radially connected to said flange (27), and eventually wound up by a winder mechanism (20), by operation of which said purge tube (11) is vertically shifted together with said purge tube holder (10).

## Patentansprüche

1. Eine Ziehvorrichtung von Einkristallstangen, die eine vollständig geschlossene Kammer (1, 2) hat, in der eingerichtet sind ein vertikales Ausblasrohr (11) zum Zufuhren eines inerten Gases in die Kammer, ein Schmelztiegel (3) zum Aufnehmen von geschmolzenem Halbleitermaterial, das kristallisiert werden soll, eine Heizeinrichtung (5), die den Schmelztiegel (3) umgibt, und ein Wärmeisolator (6), der die Heizeinrichtung (5) umgibt, wobei die genannte vollständig abgedichtete Kammer (1, 2) eine Abdeckung (2) einschließt, die einen vertikalen, zylindrischen Halsabschnitt (9) hat, dadurch gekennzeichnet, daß das genannte Ausblasrohr (11) vertikal verschiebbar in einen vertikalen Ausblasrohrhalter (10) eingesetzt ist und an dem Halter (10) verhakt werden kann, gerade bevor es durch diesen hindurchgeht, wobei der Halter (10) selbst vertikal innerhalb des vertikalen, zylindrischen Halsabschnittes (9) der Abdeckung der Kammer verschiebbar ist, daß der genannte Ausblasrohrhalter (10) an drei Drähten (39) aufgehängt ist, die mit dem Äußeren des Halters nahe seinem unteren Ende an voneinander gleich beabstandeten Stellen verbunden sind, und daß das andere Ende von jedem Draht (39) um eine jeweilige kleine Rolle (30) läuft, die in einer entsprechenden Ausnehmung (27a) vorgesehen ist, die in dem inneren Umfang eines Flansches (27) hergestellt ist, und horizontal in einem Durchlaß (27b), der in dem genannten Flansch (27) hergestellt ist, und einem horizontalen Rohr verläuft, das hermetisch und radial mit dem genannten Flansch (27) verbunden ist, und gegebenenfalls von einem Aufwickelmechanismus (20) aufgewickelt wird, durch dessen Betätigung das genannte Ausblasrohr (11) vertikal zusammen mit dem genannten Ausblasrohrhalter (10) verschoben wird.

## Revendications

1. Un appareil de tirage de lingots monocristallins possédant une chambre hermétique (1, 2) dans laquelle sont installés un tube de purge vertical (11) destiné à introduire un gaz inerte dans la chambre, un creuset (3) destiné à contenir une substance semiconductrice fondue devant être cristallisée, un dispositif de chauffage (5) entourant le creuset (3), et un isolateur calorifuge (6) entourant le dispositif de chauffage (5), ladite chambre hermétique (1, 2) englobant un couvercle (2) possédant une partie de collet verticale cylindrique (9), caractérisé en ce que ledit tube de purge (11) est inséré et peut glisser verticalement dans un support de tube de purge vertical (10) et peut être accroché par le support (10) juste avant de le traverser, ce support (10) pouvant lui-même être déplacé verticalement à l'intérieur de la partie de collet verticale cylindrique (9) du couvercle de la chambre, en ce que ledit support de tube de purge (10) est suspendu par trois fils (39) connectés à l'extérieur du support, près de son extrémité inférieure, en des emplacements équidistants les uns des autres, et en ce que l'autre extrémité de chaque fil (39) est passée autour d'une petite poulie respective (30) agencée dans un évidement respectif (27a) pratiqué dans la circonférence interne d'une bride (27), et passée horizontalement dans un passage (27b) pratiqué dans ladite bride (27), un tube horizontal étant hermétiquement et radialement connecté à ladite bride (27), et étant éventuellement enroulée par un mécanisme d'enroulement (20) dont l'actionnement entraîne le déplacement vertical du dit tube de purge (11), ensemble avec ledit support du tube de purge (10).
